# EUROPÄISCHE PATENTSCHRIFT

(11) **EP 2 944 162 B1**
(45) Veröffentlichungstag und Bekanntmachung des Hinweises auf die Patenterteilung: **29.03.2017**
(21) Anmeldenummer: 13815509.8
(22) Anmeldetag: 20.12.2013
(51) Int. Cl.: H05F 3/02

(54) **BESCHICHTUNGSSYSTEM MIT SCHUTZ VOR ELEKTROSTATISCHER ENTLADUNG**
COATING SYSTEM WITH PROTECTION AGAINST ELECTROSTATIC DISCHARGE
SYSTÈME DE REVÊTEMENT DOTÉ D'UNE PROTECTION CONTRE LES DÉCHARGES ÉLECTROSTATIQUES

(30) Priorität: 09.01.2013 EP 13150686
(43) Veröffentlichungstag der Anmeldung: 18.11.2015
(73) Patentinhaber: Sika Technology AG, 6340 Baar (CH)
(72) Erfinder: VON DER BRÜGGEN, Uwe, 74909 Meckesheim (DE); CONRAD, Lars, 74321 Bietigheim-Bissingen (DE); HEINRICH, Henry, 76316 Malsch (DE); GRÖTZINGER, Jochen, 73525 Schwäbisch Gmünd (DE)
(74) Vertreter: Sika Patent Attorneys
(86) Internationale Anmeldenummer: PCT/EP2013/077829
(87) Internationale Veröffentlichungsnummer: WO 2014/108310

(56) Entgegenhaltungen:
- EP-A1- 0 269 934
- DE-U1- 29 920 803
- US-A1- 2004 156 997

## Beschreibung

### Technisches Gebiet

Die Erfindung betrifft ein Beschichtungssystem, insbesondere ein Bodenbeschichtungssystem, auf einem Untergrund zum Schutz vor elektrostatischer Entladung und ein Verfahren zu dessen Herstellung.

### Stand der Technik

In vielen Industriebereichen werden heute hohe Ansprüche an optimale Umgebungsbedingungen gestellt. Dabei ist besonders die Vermeidung unkontrollierter elektrostatischer Auf- und Entladung von größter Bedeutung.

Elektrostatische Auf- und Entladung entsteht durch Berührung, Reibung oder Trennung zweier Stoffe. Dabei lädt sich der eine positiv und der andere negativ auf. Bei Bodenbeschichtungen wird diese Ladung durch Begehen oder Befahren, z.B. mit Gummisohlen oder Gummirädern, erzeugt. Auch durch streichende Luft kann an isolierenden Oberflächen, z.B. Lacken oder Beschichtungen, eine Aufladung entstehen.

Daher werden in sensiblen Räumen Böden und Wände mit niedrigen Erdableitwiderständen gefordert, die eine elektrostatische Aufladung sofort und kontrolliert ableiten. Für solche elektrostatisch ableitfähigen Beschichtungen existieren zahlreiche Normen, in denen Prüfverfahren zur Beurteilung von Beschichtungen auf die Eignung in Bezug auf das elektrostatische bzw. elektrische Verhalten enthalten sind.

Beispielsweise beschreibt die DIN EN 61340-4-1 Prüfverfahren zur Bestimmung des elektrischen Widerstandes von Bodenbelägen und verlegten Fußböden. In der DIN EN 61340-4-5 wird die elektrostatische Sicherheit hinsichtlich des elektrischen Widerstandes und der Aufladbarkeit von Personen, Schuhwerk und Bodenbelägen in Kombination bewertet. In der DIN VDE 0100-410 finden sich Anforderungen für den sicheren Personenschutz gegen elektrischen Schlag hinsichtlich der Gefahr, mit spannungsführenden Teilen in Kontakt zu kommen.

Um den Anforderungen gerecht zu werden, sind in der Regel elektrisch leitfähige Böden mit definiertem Widerstand erforderlich. Böden auf Basis von Zement oder Magnesia verfügen in der Regel über keine definierte elektrische Leitfähigkeit. Fußböden, die aus Kunstharzen hergestellt sind, sind gewöhnlich nicht leitfähig. Durch Modifikation der Kunstharze, z.B. durch Zugabe von Leitpigmenten, ionischen Flüssigkeiten oder leitfähigen Fasern oder Kombinationen der vorgenannter Beispiele, können aber Kunstharzbeschichtungen so eingestellt werden, dass sie exakt definierte Ableitwerte bzw. Isoliereigenschaften besitzen. Als definiert ableitfähige Bodenbeschichtungen haben sich daher leitfähig eingestellte Kunstharzbeschichtungen durchgesetzt.

Beschichtungssysteme mit ESD-Schutz (ESD = "electrostatic discharge"), d.h. mit Schutz vor elektrostatischer Entladung, sind bekannt, siehe Z.B. die EP0269934 A1. Der konventionelle Systemaufbau gemäß dem Stand der Technik ist in Figur 2 dargestellt und besteht aus folgenden Einzelschichten:
1. Ableitfähige Dünnbeschichtung 4 mit einem Erdableitwiderstand nach VDE 0100-410 von mindestens 100 kOhm
2. Ableitfähige dickschichtige Beschichtung 6 (10⁴ - 107 Ohm)
3. Leitfilm 5 und Leitset beispielsweise aus Kupferbändern zur Erdung des Systems
4. Grundierung 2 und optionale Kratzspachtelung
5. Untergrund 1, z.B. Beton

Dieses Konzept nach dem Stand der Technik weist eine Reihe von Nachteilen auf. Der Beschichtungsaufbau ist relativ komplex und erfordert z.B. einen Leitfilm. Wenn die ableitfähige Dünnbeschichtung beschädigt oder während der Nutzung unvermeidlich abgetragen wird, ist der Personenschutz nach VDE 0100-410 nicht mehr gegeben. Bei der Sanierung, die dann erforderlich ist, ist eine komplette Sanierung erforderlich, d.h. der ganze Schichtaufbau muss erneuert werden. Auch wenn bestehende Bodenbeschichtungen zu Beschichtungen mit ESD-Schutz umgerüstet werden sollen, ist es erforderlich den gesamten vorstehend beschriebenen komplexen Beschichtungsaufbau herzustellen. Dies ist zeitaufwendig und verursacht erhebliche Kosten.

### Darstellung der Erfindung

Die Aufgabe der Erfindung bestand in der Bereitstellung eines Beschichtungssystems mit ESD-Schutz, das die vorstehend genannten Nachteile nicht aufweist. Insbesondere sollte eine Kombination folgender Eigenschaften erreicht werden: ESD-Schutz, Personenschutz nach VDE 0100-410, sehr niedrige Emissionswerte für flüchtige organische Verbindungen (VOC = "volatile organic compounds", TVOC = "total volatile organic compounds"), Erhöhung der Systemrobustheit, schnelle Einbauzeit und hohe Flexibilität beim Aufrüsten bereits bestehender Beschichtungen zu ESD-Beschichtungen. Unter TVOC werden hier summarisch auch die leichtflüchtigen organischen Verbindungen (VVOC = "very volatile organic compounds"), VOC und schwerflüchtige organische Verbindungen (SVOC = "semi-volatile organic compounds") verstanden. Die vorgenannten Definitionen entsprechen denen des AgBB-Schemas, die wiederum an die Definitionen in DIN ISO 16000-6 angelehnt sind. Von besonderer Relevanz im Hinblick auf die Anwendung von Beschichtungen in Innenräumen und Aufenthaltsräumen sind Bewertungsverfahren wie AgBB (Deutschland), M1 (Finnland), DICL (Dänemark), AFSSET (Frankreich) und verschiedene Bewertungssysteme zur Charakterisierung der Nachhaltigkeit von Gebäuden. Hierzu sei stellvertretend das Verfahren der DGNB in Deutschland genannt.

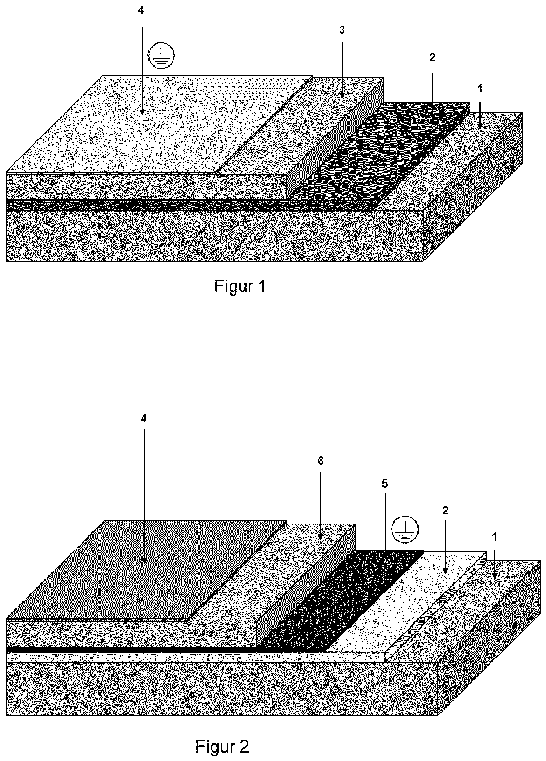

Diese Eigenschaftskombination konnte überraschenderweise durch einen Beschichtungsaufbau gemäß Figur 1 erreicht werden. Dementsprechend betrifft die Erfindung ein Beschichtungssystem auf einem Untergrund 1 zum Schutz vor elektrostatischer Entladung, umfassend in dieser Reihenfolge a) eine Grundierung 2 und optionaler Egalisierung auf dem Untergrund 1, b) eine nicht ableitfähige Kunstharzschicht 3 und c) eine ableitfähige Kunstharzschicht 4 mit einem Erdableitwiderstand nach VDE-0100-410 von mindestens 100 kOhm, wobei zwischen der ableitfähigen Kunstharzschicht 4 und der nicht ableitfähigen Kunstharzschicht 3 eine Erdungseinrichtung zur Erdung des Beschichtungssystems angeordnet ist.

Das erfindungsgemäße Beschichtungssystem kann ein Bodenbeschichtungssystem oder ein Wandbeschichtungssystem sein, wobei es sich vorzugsweise um ein Bodenbeschichtungssystem handelt. Das Beschichtungssystem besitzt eine breite gewerbliche Anwendbarkeit und weist gegenüber den Systemen nach dem Stand der Technik zahlreiche Vorteile auf.

So erfüllt das erfindungsgemäße Bodenbeschichtungssystem die Anforderungen an Personenschutz nach VDE 0100-410. Kommt es während der Nutzung des Fußbodensystems zu unvermeidbarem Materialabtrag oder Beschädigung der ableitfähigen Beschichtung, die in der Regel als Dünnschicht ausgeführt ist, steigt der Widerstand des Systems prinzipiell an und gewährleistet damit sicher und dauerhaft den erforderlichen Personenschutz. Inwieweit sich der ESD-Schutz verschlechtert oder möglicherweise nicht mehr gegeben ist, kann durch einfache Widerstandsmessungen des Systems kontrolliert werden, wie sie regelmäßig in ESD-Bereichen erforderlich sind und routinemäßig durchgeführt werden.

Außerdem eignet sich dieser Systemaufbau zur einfachen, kostengünstigen und schnellen Umnutzung von bereits bestehenden rein isolierenden Beschichtungsaufbauten in ESD-fähige Systeme. Im Falle einer Sanierung bzw. geplanten Umnutzung muss aus technischer Sicht nur die obere bevorzugt dünnschichtige Ableitschicht überarbeitet bzw. ersetzt und ein entsprechendes Leitset eingebracht werden, was zum einen erhebliche Kostenvorteile gegenüber einer vollständigen Sanierung, wie sie im konventionellen Beschichtungsaufbau notwendig wäre, zum anderen auch unter dem Aspekt Nachhaltigkeit erhebliche Vorteile bringt.

Durch eine Kombination einer leitfähigen Beschichtung mit geringer (T)VOC-Emission auf einer isolierenden Beschichtung, die ebenfalls geringe (T)VOC-Emission aufweist, kann sehr einfach ein Beschichtungssystem erhalten werden, das zusätzlich zu den vorgenannten Vorteilen auch strenge Anforderungen an das VOC-Emissionsverhalten erfüllt, wie beispielsweise das AgBB-Schema, das für Aufenthaltsräume in Deutschland gültig ist. Sehr stringente VOC-Anforderungen aus der HighTech-Industrie, z.B. aus dem Bereich Halbleiter, Optik, Lithographie, Pharma, Lifescience, Automobil, können mit dem erfindungsgemäßen Beschichtungssystem sehr einfach mit ESD-Eigenschaften verknüpft werden.

Verglichen mit einem Systemaufbau nach dem Stand der Technik wie in Figur 2 gezeigt kann erfindungsgemäß auf einen Leitfilm verzichtet werden. Dies reduziert die Komplexität des Beschichtungsaufbaus, erhöht dadurch die Robustheit durch weniger potenzielle Fehlerquellen und erlaubt einen schnelleren Einbau des Systems beim Kunden.

### Kurze Beschreibung der Zeichnung

- Fig. 1:: Prinzipskizze eines ESD-Beschichtungssystems gemäß der Erfindung
- Fig. 2:: Prinzipskizze eines ESD-Beschichtungssystems nach dem Stand der Technik

### Weg zur Ausführung der Erfindung

Das erfindungsgemäße Beschichtungssystem eignet sich für alle Böden bzw. Industrieböden und Wände, für die ein ESD-Schutz benötigt wird, insbesondere für Böden. Branchen, in denen solche Böden oder Wände benötigt werden, sind z.B. die Elektro- und Elektronikindustrie, Mikroelektronik, Feinoptik, Biotechnologie, Lithographie, Pharma, Lifescience, Automobilindustrie oder bei der Datenträgerherstellung. Die erfindungsgemäßen Beschichtungssysteme eignen sich z.B. für Reinräume, Produktionsstätten, Montagestätten, Labore usw., in denen eine elektrostatische Aufladung vermieden werden soll oder muss.

Die einzelnen Schichten des erfindungsgemäßen Beschichtungssystems sind an sich bekannt. Der Fachmann kann sie ohne weiteres mit bekannten Materialien in üblicher Weise gemäß bekannten Verfahren in zweckdienlichen Ausführungsformen, z.B. bezüglich Farbe oder Schichtdicke, herstellen.

In dem erfindungsgemäßen Beschichtungssystem kann die Schichtdicke der nicht ableitfähigen Kunstharzschicht 3 in breiten Bereichen variieren und je nach Einsatzzweck ausgewählt werden. In der Regel ist es zweckdienlich, dass die nicht ableitfähige Kunstharzschicht 3 eine dicke Schicht ist. Die nicht ableitfähige Kunstharzschicht 3 weist z.B. geeigneterweise eine Schichtdicke im Bereich von 0,5 bis 20 mm, bevorzugt von 0,5 bis 10 mm und bevorzugter von 1 bis 5 mm auf.

Die Schichtdicke der ableitfähigen Kunstharzschicht 4 kann ebenfalls in breiten Bereichen variieren und je nach Einsatzzweck ausgewählt werden. In der Regel ist es zweckdienlich, dass die ableitfähige Kunstharzschicht 4 eine Dünnschicht ist. Die ableitfähige Kunstharzschicht 4 weist z.B. eine Schichtdicke von weniger als 5 mm, geeigneterweise im Bereich von 20 bis 5000 µm, bevorzugt von 20 bis 1000 µm und bevorzugter von 20 bis 200 µm auf.

Ableitfähige Schichten können auch als elektrostatisch ableitfähige Schichten bezeichnet werden. Sie ermöglichen gegenüber nicht ableitfähigen oder isolierenden Schichten eine Ableitung von sich bildender elektrostatischer Ladung. Ableitfähige Schichten besitzen hierfür eine gewisse elektrische Leitfähigkeit. Ableitfähige und nicht ableitfähige Schichten sind dem Fachmann bekannt und er kann sie ohne weiteres herstellen.

Die Ableitfähigkeit einer Schicht kann z.B. über den Erdableitwiderstand der Schicht bestimmt werden. Wie hier verwendet und sofern nicht anders angegeben, kann der Erdableitwiderstand einer Schicht gemäß der Norm IEC 61340-4-1 bestimmt werden. Hier und gemäß der Normen IEC 61340-4-1 und IEC 61340-5-1 gilt eine Schicht als ableitfähig oder elektrostatisch ableitfähig, wenn sie einen Erdableitwiderstand von nicht mehr als 10⁹ Ohm aufweist. Schichten mit einem größeren Erdableitwiderstand sind nicht ableitfähig.

Der Erdableitwiderstand wird dabei bei den Schichten, die sich in verlegter Form oberhalb des Leitsets befinden, bestimmt wie in IEC 61340-4-1 beschrieben. Der Erdableitwiderstand einer darunterliegenden Schicht ist für die ESD-Eigenschaften des Beschichtungssystems nicht relevant. Eine Messung des Erdableitwiderstands ist daher dort nicht notwendig.

In dem erfindungsgemäßen Beschichtungssystem weist die ableitfähige Kunstharzschicht 4 einen Erdableitwiderstand nach VDE 0100-410 (VDE-0100-410 Anhang C 1.5 (Anforderungsnorm); VDE-0100-600 Anhang A (Messnorm)) von mindestens 100 kOhm auf.

Der Erdableitwiderstand sowie der Systemwiderstand gemäß der Normenserie IEC 61340 kann in breiten Bereichen variieren, soweit die Ableitfähigkeit gegeben ist. Die ableitfähige Kunstharzschicht 4 weist z.B. geeigneterweise eine Erdableitwiderstand bzw. einen Systemwiderstand von nicht mehr als 10⁹ Ohm und bevorzugt nicht mehr als 2,5 x 10⁸ Ohm auf, der Erdableitwiderstand kann z.B. bevorzugt im Bereich von 10⁶ Ohm bis 2,5 x 10⁸ Ohm liegen. Die Spannung, mit der sich ein Körper unter definierten Bedingungen wie in IEC 61340-4-5 beschrieben (sogenannte "Body Voltage") aufladen darf, ist dabei gemäß IEC 61340-5-1 bevorzugt auf kleiner 100 Volt beschränkt.

Bei der nicht ableitfähigen Kunstharzschicht 3 handelt es sich um eine isolierende Schicht. Der Erdableitwiderstand der nicht ableitfähigen Kunstharzschicht 3 kann in breiten Bereichen variieren, soweit keine Ableitfähigkeit gegeben ist. Die nicht ableitfähige Kunstharzschicht 3 kann z.B. einen Erdableitwiderstand von mehr als 10⁹ Ohm, geeigneterweise mindestens 10¹⁰ Ohm und bevorzugt mindestens 10¹¹ Ohm aufweisen. Der Erdableitwiderstand der nicht ableitfähige Kunstharzschicht 3 kann gemäß der Norm IEC 61340-4-1 bestimmt werden bevor die Erdungseinrichtung montiert und die ableitfähige Kunstharzschicht 4 aufgebracht werden. Eine Messung ist aber in der Regel unnötig, da die in Frage kommenden Kunstharzschichten per se Isolatoren sind und diese Bedingung erfüllen, sofern keine leitfähigen Zusätze beigemischt werden.

Die nicht ableitfähige Kunstharzschicht 3, die ableitfähige Kunstharzschicht 4 und, sofern als Grundierung die bevorzugte Kunstharz-Grundierung eingesetzt wird, auch die Grundierung basieren auf einem Kunstharz. Auch die optionale Kratzspachtelung kann auf einem Kunstharz basieren. Kunstharzschichten als Bodenbeläge oder Wandbeläge sind dem Fachmann wohlbekannt und werden auf dem Gebiet in großem Umfang eingesetzt. Sofern nicht anders angegeben, beziehen sich die folgenden Ausführungen gleichermaßen auf die Kunstharzschichten 3 und 4 und die Kunstharz-Grundierung und die optionale Kratzspachtelung.

Kunstharzschichten werden aus gehärteten Reaktionsharzen oder Reaktionsharzmassen gebildet, wobei unter Reaktionsharzmassen üblicherweise Reaktionsharze verstanden werden, die ein oder mehrere Additive, z.B. Füllstoffe und/oder Lösemittel, enthalten. Zur Bildung der Kunstharzschichten werden Reaktionsharze, gewöhnlich mithilfe eines Härters, der auch Beschleuniger enthalten kann, zur Reaktion gebracht. Die Reaktion führt zur Viskositätserhöhung und schließlich zur Härtung des Reaktionsharzes. Man erhält ein Kunstharz, das gewöhnlich duroplastisch ist.

Solche Reaktionsharzsysteme sind in großer Vielfalt im Handel erhältlich. Häufig handelt es sich um Zweikomponentensysteme, bei denen die eine Komponente das Reaktionsharz und die andere den Härter oder Beschleuniger umfasst. Ferner werden auch 3- oder höherkomponentige Systeme eingesetzt, z.B. wenn zusätzlich ein Zementbindemittel oder gebräuchliche oder spezielle Füllstoffgemische eingesetzt werden. Es sind auch einkomponentige Systeme möglich. Bei Systemen mit zwei, drei oder mehr Komponenten werden die Komponenten miteinander gemischt und dann verarbeitet. Durch chemische Reaktion nach der Mischung härten die Reaktionsharze nach einer gewissen Zeit aus und bilden so die Schicht. Die Reaktionsharze können z.B. für die Verarbeitung selbstverlaufend oder spachtelfähig eingestellt werden.

Zur Herstellung der nicht ableitfähigen Kunstharzschicht 3, der ableitfähigen Kunstharzschicht 4 und gegebenenfalls der Kunstharz-Grundierung 2 und der optionalen Kratzspachtelung können alle üblichen, dem Fachmann bekannten Reaktionsharze eingesetzt werden. Für die einzelnen Schichten können die gleichen oder unterschiedliche Reaktionsharze verwendet werden. Die Reaktionsharze, insbesondere die nachstehend genannten, können in lösemittelhaltiger, lösemittelfreier oder wasserbasierender Form eingesetzt werden.

Die Reaktionsharze, die für die jeweilige Schicht oder gegebenenfalls die Grundierung oder die Kratzspachtelung eingesetzt werden, werden unabhängig voneinander bevorzugt ausgewählt aus Epoxidharzen, Polyurethanen, Polyharnstoffen, Gemischen von Polyurethanen und Polyharnstoffen, Poly(meth)acrylaten, zementösen Hybridsystemen und polymervergüteten zementösen Mischungen (PCC "polymer cement concrete"). Besonders bevorzugte Reaktionsharze für die einzelnen Schichten werden nachstehend bei der Beschreibung der einzelnen Schichten aufgeführt.

Unter Reaktionsharzen zur Herstellung der Kunstharze werden hier auch Reaktionsharze verstanden, die Anteile von Zement enthalten, wie die vorstehend genannten zementösen Hybridsysteme und polymervergüteten zementösen Mischungen. Auch solche zementhaltigen Reaktionsharze sind im Handel erhältlich. Zementöse Hybridsysteme werden z.B. von der Sika AG vertrieben, z.B. Sikafloor^{®}-EpoCem-Produkte, ein Dreikomponentensystem, das Epoxidharz und Zement umfasst, oder Sikafloor^{®}-PurCem-Produkte, ebenfalls ein Dreikomponentensystem umfassend Polyurethanharz und eine zementöse Komponente. Weiterhin werden auch zwei- und dreikomponentige Kunstharze darunter verstanden wie die Sikafloor^{®}-HyCem-Produkte, bei denen eine Komponente aus Kunstharzdispersionen oder Kunstharzemulsionen bestehen kann.

Die Kunstharzschichten 3 und 4, die Grundierung und die optionale Kratzspachtelung können nach Bedarf unabhängig voneinander ein oder mehrere Additive enthalten. Durch Zugabe von Additiven zu den Reaktionsharzen können die Eigenschaften der daraus gebildeten Kunstharzschichten modifiziert werden. Durch Additive können z.B. die elektrischen oder mechanischen Eigenschaften, die Viskosität oder die Farbe der Kunstharzschichten eingestellt werden. Naturgemäß können für die Kunstharzschichten 3 und 4, die Grundierung und die optionale Kratzspachtelung je nach gewünschter Modifikation unterschiedliche Additive Verwendung finden.

Die Additive können in dem Reaktionsharz bereits enthalten sein oder dem Reaktionsharz vor der Verarbeitung zugemischt werden.

Beispiele für mögliche Additive sind, neben Lösemittel und Wasser, farbgebende Mittel, wie Farbquarze, Farbstoffe, Pigmente und Farbchips, Füllstoffe, wie Quarzsande, keramische Pulver, Sand, Kreide, Fasern, Hohlkugeln und Glasperlen, Emulgatoren, Thixotropiermittel, Filmbildehilfsmittel.

Als Additive zur Einstellung der elektrischen Eigenschaften, durch die insbesondere die Ableitfähigkeit der ableitfähigen Schicht 4 eingestellt werden kann, eignen sich leitfähige Additive, wie leitfähige Füllstoffe, wie Leitpigmente oder leitfähige Fasern, Salze, ionische Flüssigkeiten, ionische und nicht-ionische Tenside sowie Kombinationen davon. Konkrete leitfähige Additive zur Einstellung der elektrischen Eigenschaften sind z.B. Kohlenstofffasern, Ruß, Graphit, Siliciumcarbid, Metalloxide, Metalle, wie Eisen, Ammoniumsalze, metallhaltige oder schwermetallhaltige Füllstoffe, insbesondere antimon- und zinnhaltige Füllstoffe auf Basis Titandioxid oder Glimmer, ionische Flüssigkeiten, ionische und nicht-ionische Tenside, Melaminsulfonate und Polycarboxylatether und Kombinationen davon. Die leitfähigen Additive zur Einstellung der elektrischen Eigenschaften können z.B. in Form von Pulvern, Fasern, Spänen, in flüssiger Form, Flakes oder Granulat eingesetzt werden. Leitfähige Salze können gegebenenfalls auch als Lösungen zugesetzt werden.

Als Untergrund 1 für die Beschichtung, insbesondere die Boden- bzw. Fußbodenbeschichtung, eignen sich prinzipiell alle Untergründe, die in Bauwerken vorhanden sind. Beispiele für geeignete Untergründe sind Beton, Zement-Estrich, Magnesia-Estrich, Keramikfliesen, Asphalt und gegebenenfalls bereits bestehende Kunstharzbeschichtungen.

Zur Herstellung des erfindungsgemäßen Beschichtungssystems wird auf die Unterlage, gegebenenfalls nach üblicher Untergrundvorbehandlung, wie z.B. Schleifen, Sandstrahlen, Kugelstrahlen oder Ablaugen mit Lösemitteln oder Säuren, zunächst die Grundierung 2 aufgebracht. Für die Grundierung wird eine übliche Grundierungszusammensetzung aufgebracht, z.B. ein Reaktionsharz bzw. eine Reaktionsharzmasse oder alternativ auch eine Kunstharzdispersion auf wässriger Basis und gehärtet. Bevorzugt handelt es sich um eine Kunstharz-Grundierung auf Basis von gehärteten Reaktionsharzen.

Bevorzugte Reaktionsharze für die Kunstharz-Grundierung wurden bereits vorstehend genannt. Die Kunstharz-Grundierung kann bevorzugt aus einem gehärteten Epoxidharz oder einem zementösen Hybridsystem gebildet sein. Als mögliche Additive, die die Grundierung, insbesondere die Kunstharz-Grundierung, enthalten kann, kommen z.B. Füllstoffe, Farbpigmente, Farbstoffe, Thixotropierhilfsmittel, Entlüftungshilfsmittel, Haftvermittler wie beispielsweise Silane, in Betracht. Als geeignete Handelsprodukte, die zur Herstellung der Grundierung eingesetzt werden können, können beispielhaft Sikafloor^{®}-156, -160, -161, -144 und -1410 der Sika AG genannt werden, bei denen es sich um zweikomponentige Epoxidharze handelt.

Optional kann auf die Grundierung 2 ein Kratzspachtel aufgebracht und gehärtet werden. Dies kann zur Egalisierung zweckmäßig sein, z.B. wenn der Untergrund uneben ist. Zur Kratzspachtelung können alle üblichen Kratzspachtel eingesetzt werden. Es eignen sich z.B. alle Reaktionsharze, insbesondere die für die Kunstharz-Grundierung genannten, die zusätzlich mit einem Füllstoff, wie z.B. Quarzsand, Quarzmehl oder Kreide verfüllt werden. Mit Quarzsand verfülltes Sikafloor^{®}-156, -160, -161, -144 und -1410 sind z.B. gut geeignet.

Auf die Grundierung oder, sofern eine Kratzspachtelung aufgebracht wurde, auf die Kratzspachtelung wird dann die Reaktionsharzzusammensetzung für die nicht ableitfähige Kunstharzschicht 3 aufgebracht und gehärtet. Wie bereits vorstehend erwähnt sind Kunstharze gewöhnlich nicht leitfähig und nicht ableitfähig. Solche nicht ableitfähigen Kunstharzschichten können so hergestellt werden, dass sie eine sehr geringe Emission von flüchtigen organischen Verbindungen zeigen, was wie vorstehend erläutert sehr vorteilhaft ist.

Bevorzugte Reaktionsharze für die nicht ableitfähige Kunstharzschicht 3 wurden bereits vorstehend genannt. Die nicht ableitfähige Kunstharzschicht kann bevorzugt aus gehärtetem Epoxidharz, Polyurethan, Gemischen aus Epoxidharz und Polyurethan, Polyharnstoff, Gemischen aus Polyurethanen und -harnstoffen, Polyestern, Poly(meth)acrylaten, zementösem Hybridsystem oder einer Dispersionsbeschichtung gebildet sein. In einer bevorzugten Ausführungsform können lösemittelfreie Reaktionsharze zur Herstellung der nicht ableitfähigen Kunstharzschicht 3 eingesetzt werden. Als mögliche Additive, die die nicht ableitfähigen Kunstharzschicht enthalten kann, kommen z.B. Füllstoffe, Farbpigmente, Farbstoffe, Thixotropierhilfsmittel, Entlüftungshilfsmittel, Haftvermittler, wie beispielsweise Silane, in Betracht. Als geeignete Handelsprodukte, die zur Herstellung der nicht ableitfähige Kunstharzschicht eingesetzt werden können, können beispielhaft Sikafloor^{®}-264, Sikafloor^{®}-266CR und Sikafloor^{®}-269CR der Sika AG genannt werden, bei denen es sich um zweikomponentige Epoxidharze handelt. Sikafloor^{®}-266CR und Sikafloor^{®}-269CR sind lösemittelfreie Systeme, so dass sie eine äußerst geringe TVOC-Emission aufweisen. Ergänzend können auch zweikomponentige Polyurethanbschichtungen der Sika AG genannt werden, wie beispielsweise Sikafloor^{®}-300N und Sikafloor^{®}-326, die ebenfalls äußerst geringe TVOC-Emissionen aufweisen.

Ein besonderer Vorteil des erfindungsgemäßen Systems kommt zum tragen, wenn eine bereits bestehende Beschichtung zu ESD-Beschichtungssystemen aufgerüstet werden soll. Da übliche Beschichtungen häufig als oberste Schicht eine nicht ableitfähige Beschichtung aufweisen, kann diese als nicht ableitfähige Kunstharzschicht 3 dienen. Für die Aufrüstung ist dann nur noch notwendig, die Erdungseinrichtung zu montieren und mit der ableitfähigen Kunstharzschicht 4 zu überschichten. Eine Komplettsanierung wie es bei den ESD-Systemen nach dem Stand der Technik erforderlich wäre, ist nicht nötig.

Auf die gehärtete nicht ableitfähige Kunstharzschicht 3 wird die Erdungseinrichtung zur Erdung des Beschichtungssystems montiert. Die Erdungseinrichtung wird zum elektrischen Anschluss der elektrostatisch ableitfähigen Beschichtung mit dem Potentialausgleich verbunden. Solche Erdungseinrichtungen sind dem Fachmann bekannt und er kann sie ohne weiteres ausführen. Die Erdungseinrichtung kann z.B. durch einen Erdungsleiter oder eine Anordnung von Erdungsleitern gebildet werden, die mit dem Potentialausgleich verbunden werden. Die Verbindung mit den Potentialausgleich oder Erdpotential kann über einen oder mehrere Erdungsanschlüsse erfolgen.

Als Erdungsleiter eignen sich z.B. Kupferbänder und/oder sogenannte Leitsets, die zur Ableitung des Potentials verlegt werden. Es können selbstklebende Kupferbänder eingesetzt werden, die in einfacher Weise auf die nicht ableitfähige Schicht 3 angebracht werden können. Leitsets sind im Handel erhältlich, z.B. Sikafloor^{®}-Leitset. Bei dem Leitset handelt es sich um Dübel mit Kupferbändern, Unterlagscheiben und einer Gewindestange. Damit wird ein sogenannter Erdableitpunkt hergestellt, der nachfolgend von einer elektrotechnischen Fachkraft an die Erdung angeschlossen werden kann.

Wie vorstehend erläutert, ist es bei ESD-Beschichtungssystemen nach dem Stand der Technik erforderlich, dass in dem Beschichtungssystem ein Leitfilm vorgesehen ist. Hierbei handelt es sich um eine elektrostatisch hoch ableitfähige dünne Schicht. Erfindungsgemäß ist ein solcher Leitfilm im Beschichtungssystem nicht notwendig, so dass darauf verzichtet werden kann. Erfindungsgemäß ist es daher bevorzugt, dass im Beschichtungssystem kein Leitfilm angeordnet ist, insbesondere nicht auf der Grundierung.

Auf die Erdungseinrichtung und die nicht ableitfähige Kunstharzschicht 3 wird die Reaktionsharzzusammensetzung für die ableitfähige Kunstharzschicht 4 aufgebracht und gehärtet. Die ableitfähige Kunstharzschicht 4 ist die Deckschicht und fungiert als elektrostatisch ableitfähige Oberfläche des Beschichtungssystems. Bevorzugte Reaktionsharze für die ableitfähige Kunstharzschicht 4 wurden bereits vorstehend genannt. Die nicht ableitfähige Kunstharzschicht kann bevorzugt aus gehärtetem Epoxidharz, Polyurethan, Polyharnstoff oder Polyurethan-Polyharnstoffgemisch gebildet sein.

Wie bereits vorstehend erwähnt sind Kunstharze gewöhnlich nicht leitfähig und nicht ableitfähig. Die Maßnahmen zur Herstellung einer ableitfähigen Kunstharzschicht sind dem Fachmann bekannt. Die Einstellung kann z.B. in einfacher Weise durch Zugabe von leitfähigen Additiven zum Reaktionsharz für die ableitfähige Schicht erfolgen. Die ableitfähige Kunstharzschicht 4 enthält daher bevorzugt ein oder mehrere leitfähige Additive. Beispiele für geeignete leitfähige Additive wurden vorstehend aufgeführt. Durch die Wahl der Art und der Menge an zugesetztem leitfähigem Additiv im Reaktionsharz kann der Fachmann den Grad der Ableitfähigkeit der Harzschicht, z.B. ausgedrückt im Erdableitwiderstand, definiert einstellen.

Als mögliche weitere Additive, die die ableitfähige Kunstharzschicht 4 enthalten kann, kommen z.B. Füllstoffe, Farbpigmente, Farbstoffe, Thixotropierhilfsmittel, Entlüftungshilfsmittel, Haftvermittler, wie beispielsweise Silane, in Betracht.

Im Handel sind Reaktionsharzprodukte zur Herstellung von ableitfähigen Kunstharzschichten erhältlich, die für ESD-Beschichtungssysteme geeignet sind. Beispielhaft können Sikafloor^{®}-230ESD Topcoat und Sikafloor^{®}-305W ESD der Sika AG genannt werden. Sikafloor^{®}-230ESD Topcoat ist ein leitfähiges zweikomponentiges Epoxidharzsystem. Sikafloor^{®}-305W ESD ist ein leitfähiges zweikomponentiges Polyurethansystem.

Allgemeine Verarbeitungsmethoden und einsetzbare Verarbeitungsgeräte zur Herstellung der einzelnen Schichten sind dem Fachmann bekannt. Spezielle Hinweise für die Verarbeitung bestimmter im Handel erhältlicher Reaktionsharzprodukte sind in der Regel auch den dazugehörigen Produktdatenblätter zu entnehmen.

Die einzelnen Schichten können auch als Doppelschichten oder Mehrfachschichten ausgebildet sein, das ist aber im Allgemeinen nicht bevorzugt. Es ist auch möglich, dass gegebenenfalls zusätzliche Zwischenschichten im Beschichtungssystem angeordnet sind. Beispiele für solche Zwischenschichten sind solche, die auch rissüberbrückende Eigenschaften aufweisen (z.B. Sika-floor^{®}-350 oder Sikafloor^{®}-390). Zwischenschichten sind aber nicht bevorzugt. In einer bevorzugten Ausführungsform besteht das erfindungsgemäße Beschichtungssystem aus der Grundierung 2, der nicht ableitfähigen Kunstharzschicht 3, der Erdungseinrichtung und der ableitfähigen Kunstharzschicht 4 wie beschrieben und in den Ansprüchen definiert, wobei gegebenenfalls zwischen der Grundierung 2 und der nicht ableitfähigen Kunstharzschicht 3 eine Kratzspachtelung angeordnet ist.

### Bezugszeichenliste

- 1: Unterlage
- 2: Grundierung
- 3: nicht ableitfähige (isolierende) Kunstharzschicht
- 4: ableitfähige Kunstharzschicht
- 5: Leitfilm
- 6: ableitfähige Kunstharzschicht

### Beispiele

Es wurde folgendes ESD-VOC-VDE0100-Beschichtungssystem entsprechend Figur 1 hergestellt:
Grundierung: Sikafloor^{®}-161; Schichtdicke 500µm
Nicht ableitfähige Kunstharzbeschichtung: Sikafloor^{®}-264; Schichtdicke 1500µm
Ableitfähige Kunstharzbeschichtung: Sikafloor^{®}-230 ESD TopCoat; Schichtdicke 80µm

Vor Aufbringung der ableitfähigen Kunstharzbeschichtung wurde auf der aufgebrachten nicht ableitfähigen Kunstharzbeschichtung ein Sikafloor^{®}-Leitset analog zur Montageanleitung montiert:
1) Loch D=8mm / 50mm tief bohren, Bohrstelle staubfrei säubern.
2) Kunststoffdübel bündig setzen, Stockschraube mit Inbusschlüssel in Dübel so weit einschrauben, bis sie 16mm heraus ragt.
3) Kupferstreifen an Boden kleben.
4) Unterlegscheiben (D=60mm) und (D=30mm) mit Mutter auf Stockschraube festschrauben, Plastikschlauch auf Stockschraube fest aufsetzen und nach rechts fest anziehen.
5) Elektrostatisch ableitfähige Bodenbeschichtung aufbringen.
6) Nach vollständiger Aushärtung der Bodenbeschichtung Plastikschlauch abziehen und Kontaktfläche auf der Mutter säubern.
7) Anschlussöse aufsetzen und mit selbstsichernder Mutter fest anziehen.
8) Erdungskabel in die Anschlussöse quetschen, diese Arbeit ist von einer Elektrofachkraft auszuführen.

Die elektrostatischen Eigenschaften entsprechender Beschichtungssysteme auf verschiedenen Unterlagen wurde untersucht. Die Ergebnisse sind in nachstehender Tabelle wiedergegeben. Es finden sich auch Angaben zu den Umgebungsbedingungen (absolute Feuchte).

**Tabelle: Elektrostatische Eigenschaften des gemäß Figur 1 beschriebenen Beschichtungsaufbaus**

| Bezeichnung Testfläche | Erdableitwiderstand | | Svstemwiderstand | | Körperspannung | | Ableitwiderstand für Personenschutz | | Anmerkung |
|---|---|---|---|---|---|---|---|---|---|
| | maximaler Messwert gemäß IEC 61340-4-1 (MΩ)¹⁾ | Anforderung gemäß IEC 61340-5-1 (MΩ) | maximaler Messwert gemäß IEC 61340-4-5 (MΩ)²⁾ | Anforderung gemäß IEC 61340-5-1 (MΩ) | maximaler Messwert gemäß IEC 61340-4-5 (V)³⁾ | Anforderung gemäß IEC 61340-5-1 (V) | minimaler Messwert gemäß VDE-0100-600⁴⁾ (kΩ) | Anforderung gemäß VDE-0100-410 (kQ) für Spannungen > 500 V | |
| Büro LC | 7 | | n.b. | | n.b. | | 220 | | Gemessen 7 Tage nach Aufbringen der letzten Schicht |
| Büro LC | 5 | | n.b. | | n.b. | | 870 | | Gemessen 470 Tage nach Aufbringen der letzten Schicht |
| Büro LC | n.b. | | 403 | | 8 | | n.b. | | Gemessen mit ESD-Schuhen von Hersteller A 35 Tage nach Aufbringen der letzten Schicht bei einer Luftfeuchte von 5,0 g/m³ |
| Büro LC | n.b. | | n.b. | | 12 | | n.b. | | Gemessen mit ESD-Schuhen von Hersteller A 202 Tage nach Aufbringen der letzten Schicht bei einer Luftfeuchte von 6,6 g/m³ |
| Büro LC | n.b. | | n.b. | | 14 | | n.b. | | Gemessen mit ESD-Schuhen von Hersteller B 281 Tage nach Aufbringen der letzten Schicht bei einer Luftfeuchte von 5,0 g/m³ |
| Büro LC | n.b. | | n.b. | | 4 | | n.b. | | Gemessen mit ESD-Schuhen von Hersteller B 370 Tage nach Aufbringen der letzten Schicht bei einer Luftfeuchte von 4,8 g/m³ |
| Keller | 30 | < 1000 | n.b. | <1000 | n.b. | < 100 | 680 | >100 | Gemessen 12 Tage nach Aufbringen der letzten Schicht |
| Keller | n.b. | | 457 | | n.b. | | n.b. | | Gemessen mit ESD-Schuhen von Hersteller A 88 Tage nach Aufbringen der letzten Schicht bei einer Luftfeuchte von 5,1 g/m³ |
| Keller | 105 | | n.b. | | n.b. | | 3600 | | Gemessen 550 Tage nach Aufbringen der letzten Schicht |
| Laborplatte | n.b. | | 120 | | n.b. | | n.b. | | Wert ermittelt im Klimaschrank bei einer Luftfeuchte von 2,5 g/m³; Gewicht des ESD-Schuhs 12,5 kg gemäß IEC 61340-4-3 |
| Laborplatte | n.b. | | 280 | | n.b. | | n.b. | | Wert ermittelt im Klimaschrank bei einer Luftfeuchte von 5,1 g/m³; Gewicht des ESD-Schuhs 12,5 kg gemäß IEC 61340-4-3 |
| Laborplatte | n.b. | | 107 | | n.b. | | n.b. | | Wert ermittelt im Klimaschrank bei einer Luftfeuchte von 10,3 g/m³; Gewicht des ESD-Schuhs 12,5 kg gemäß IEC 61340-4-3 |

| | | | | | | | | | |
|---|---|---|---|---|---|---|---|---|---|
| 1.) Messpg. 100 V; Elektrodengewicht 2,5 kg 2) Messpg. 100 V; Handelektrode-Person-ESD-Schuhe gemäß IEC 61340-4-3-Beschichtungssystem 3.) Field Meter Set PFK-100 Firma PROSTAT sowie Analog-Digital Converter Agilent 34410 A mit Auswertungssoftware 4.) Plattenelektrode mit nassem Vlies; Gleichspg. 1000 V | | | | | | | | | |

## Patentansprüche

1. Beschichtungssystem auf einem Untergrund (1) zum Schutz vor elektrostatischer Entladung, umfassend in dieser Reihenfolge
a) eine Grundierung (2) auf dem Untergrund (1),
b) eine nicht ableitfähige Kunstharzschicht (3) und
c) eine ableitfähige Kunstharzschicht (4) mit einem Erdableitwiderstand nach VDE-0100-410 von mindestens 100 kOhm,
wobei zwischen der ableitfähigen Kunstharzschicht (4) und der nicht ableitfähigen Kunstharzschicht (3) eine Erdungseinrichtung zur Erdung des Beschichtungssystems angeordnet ist.

2. Beschichtungssystem nach Anspruch 1, wobei das Beschichtungssystem ein Bodenbeschichtungssystem ist.

3. Beschichtungssystem nach Anspruch 1 oder Anspruch 2, wobei das Beschichtungssystem keinen Leitfilm (5) aufweist.

4. Beschichtungssystem nach irgendeinem der Ansprüche 1 bis 3, wobei zwischen der Grundierung (2) und der nicht ableitfähigen Kunstharzschicht (3) eine Kratzspachtelung zur Egalisierung angeordnet ist.

5. Beschichtungssystem nach irgendeinem der Ansprüche 1 bis 4, wobei die nicht ableitfähige Kunstharzschicht (3) eine Schichtdicke im Bereich von 0,5 bis 20 mm aufweist und/oder wobei die ableitfähige Kunstharzschicht (4) eine Schichtdicke im Bereich von 20 bis 5000 µm aufweist.

6. Beschichtungssystem nach irgendeinem der Ansprüche 1 bis 5, wobei die nicht ableitfähige Kunstharzschicht (3) und/oder die ableitfähige Kunstharzschicht (4) eine sehr geringe TVOC-Emission aufweist.

7. Beschichtungssystem nach irgendeinem der Ansprüche 1 bis 6, wobei die nicht ableitfähige Kunstharzschicht (3) einen Erdableitwiderstand von mehr als 10⁹ Ohm, bestimmt gemäß IEC 61340-4-1, aufweist und/oder wobei die ableitfähige Kunstharzschicht (4) einen Erdableitwiderstand von nicht mehr als 10⁹ Ohm, bestimmt gemäß IEC 61340-4-1, aufweist.

8. Beschichtungssystem nach irgendeinem der Ansprüche 1 bis 7, wobei die Kunstharzschichten (3) und (4) und die Kunstharz-Grundierung aus gehärteten Reaktionsharzen bzw. Reaktionsharzmassen gebildet sind, die gegebenenfalls ein oder mehrere Additive enthalten, wobei die Reaktionsharze, die für die jeweilige Schicht oder Grundierung eingesetzt werden, unabhängig voneinander ausgewählt sind aus Epoxidharzen, Polyurethanen, Polyharnstoffen, Gemischen aus Polyurethanen und Polyharnstoffen, Polymethacrylaten, Polyacrylaten, zementösen Hybridsystemen und polymervergüteten zementösen Mischungen (PCC).

9. Beschichtungssystem nach irgendeinem der Ansprüche 1 bis 8, wobei in der nicht ableitfähigen Kunstharzschicht (3) ein oder mehrere Additive ausgewählt aus Lösemittel und Wasser, farbgebenden Mitteln, wie Farbquarzen, Farbstoffen, Pigmenten und Farbchips, Füllstoffen, wie Quarzsanden, keramischen Pulvern, Sand, Kreide, Fasern, Hohlkugeln und Glasperlen, Emulgatoren, Thixotropiermitteln, Filmbildehilfsmitteln enthalten sind.

10. Beschichtungssystem nach irgendeinem der Ansprüche 1 bis 9, wobei in der ableitfähigen Kunstharzschicht (4) ein oder mehrere leitfähige Additive zur Einstellung der elektrischen Eigenschaften enthalten sind, z.B. Kohlenstofffasern, Ruß, Graphit, Siliciumcarbid, Metalloxide, Metalle, wie Eisen, Ammoniumsalze, schwermetallhaltige oder metallhaltige Füllstoffe, insbesondere antimon- und zinnhaltige Füllstoffe auf Basis Titandioxid oder Glimmer, ionische Flüssigkeiten, ionische und nicht-ionische Tenside, Melaminsulfonate und Polycarboxylatether.

11. Beschichtungssystem nach irgendeinem der Ansprüche 1 bis 10, wobei der Systemwiderstand kleiner 10⁹ Ohm ist und/oder die Personenaufladung ("Body Voltage") kleiner 100 Volt ist, gemessen nach IEC-61340-4-5.

12. Verfahren zur Herstellung eines Beschichtungssystems auf einem Untergrund (1) zum Schutz vor elektrostatischer Entladung nach irgendeinem der Ansprüche 1 bis 15, umfassend die folgenden Schritte
a) Aufbringen einer Grundierungszusammensetzung auf dem Untergrund (1) und Härten zur Bildung einer Grundierung (2),
b) gegebenenfalls Aufbringen und Härten eines Kratzspachtels auf die Grundierung zur Egalisierung,
c) Aufbringen einer Reaktionsharzzusammensetzung auf die Grundierung oder die Kratzspachtelung und Härten zur Bildung einer nicht ableitfähigen Kunstharzschicht (3),
d) Montieren einer Erdungseinrichtung auf die nicht ableitfähige Kunstharzschicht (3) zur Erdung des Beschichtungssystems,
e) Aufbringen einer Reaktionsharzzusammensetzung über der Erdungseinrichtung und der nicht ableitfähigen Kunstharzschicht (3) und Härten zur Bildung der ableitfähigen Kunstharzschicht (4) mit einem Erdableitwiderstand nach VDE-0100-410 von mindestens 100 kOhm.

13. Verfahren zur Umrüstung eines bereits bestehenden Beschichtungssystems, das in dieser Reihenfolge a) eine Grundierung (2) auf dem Untergrund (1), gegebenenfalls eine Kratzspachtelung zur Egalisierung, und b) eine nicht ableitfähige Kunstharzschicht (3) umfasst, zur Herstellung eines Beschichtungssystems auf einem Untergrund (1) zum Schutz vor elektrostatischer Entladung nach irgendeinem der Ansprüche 1 bis 15, umfassend die folgenden Schritte
a) Montieren einer Erdungseinrichtung auf die nicht ableitfähige Kunstharzschicht (3) des bereits bestehenden Beschichtungssystems zur Erdung des Beschichtungssystems und
b) Aufbringen einer Reaktionsharzzusammensetzung über der Erdungseinrichtung und der nicht ableitfähigen Kunstharzschicht (3) und Härten zur Bildung der ableitfähigen Kunstharzschicht (4) mit einem Erdableitwiderstand nach VDE-0100-410 von mindestens 100 kOhm.

14. Verfahren zur Sanierung eines Beschichtungssystems auf einem Untergrund (1) zum Schutz vor elektrostatischer Entladung nach irgendeinem der Ansprüche 1 bis 11, bei dem die ableitfähige Kunstharzschicht (4) teilweise abgenutzt ist, umfassend
a) das Aufbringen einer Reaktionsharzzusammensetzung über der ableitfähigen Kunstharzschicht (4) und Härten zur Bildung der ableitfähigen Kunstharzschicht (4) mit einem Erdableitwiderstand nach VDE-0100-410 von mindestens 100 kOhm.

15. Verfahren nach einem der Ansprüche 13 oder 14, wobei vor dem Aufbringen der neuen ableitfähigen Kunstharzschicht (4) die bereits vorhandene teilweise abgenutzte ableitfähige Kunstharzschicht (4) oder vor der Montage der Erdungseinrichtung, die bereits vorhandene nicht ableitfähige Kunstharzschicht (3) einer Vorbehandlung unterworfen wird, wie z.B. Schleifen, Sandstrahlen, Kugelstrahlen oder Ablaugen mit Lösemitteln oder Säuren.

## Claims

1. A coating system on a substrate (1) for the protection against electrostatic discharge, comprising in the following order
a) an undercoat (2) on the substrate (1),
b) a non-dissipative synthetic resin layer (3) and
c) a dissipative synthetic resin layer (4) having a resistance to ground according to VDE-0100-410 of at least 100 kohm,
wherein a grounding device for grounding the coating system is arranged between the dissipative synthetic resin layer (4) and the non-dissipative synthetic resin layer (3).

2. The coating system according to claim 1, wherein the coating system is a floor coating system.

3. The coating system according to claim 1 or claim 2, wherein the coating system has no conductive film (5).

4. The coating system according to any one of claims 1 to 3, wherein a scratch coat for leveling is arranged between the undercoat (2) and the non-dissipative synthetic resin layer (3).

5. The coating system according to any one of claims 1 to 4, wherein the non-dissipative synthetic resin layer (3) has a layer thickness in the range of 0.5 to 20 mm and/or wherein the dissipative synthetic resin layer (4) has a layer thickness in the range of 20 to 5000 µm.

6. The coating system according to any one of claims 1 to 5, wherein the non-dissipative synthetic resin layer (3) and/or the dissipative synthetic resin layer (4) have very low TVOC emission.

7. The coating system according to any one of claims 1 to 6, wherein the non-dissipative synthetic resin layer (3) has a resistance to ground of more than 10⁹ ohm, determined according to IEC 61340-4-1, and/or wherein the dissipative synthetic resin layer (4) has a resistance to ground of no more than 10⁹ ohm, determined according to IEC 61340-4-1.

8. The coating system according to any one of claims 1 to 7, wherein the synthetic resin layers (3) and (4) and the synthetic resin undercoat are made of cured reaction resins or reaction resin compounds, which optionally contain one or more additives, the reaction resins that are used for the respective layer or undercoat independently of one another being selected from epoxy resins, polyurethanes, polyureas, mixtures of polyurethanes and polyureas, polymethacrylates, polyacrylates, cementitious hybrid systems, and polymer-modified cementitious mixtures (PCC).

9. The coating system according to any one of claims 1 to 8, wherein the non-dissipative synthetic resin layer (3) contains one or more additives selected from solvents and water, coloring agents such as colored quartz, dyes, pigments and color chips; fillers, such as quartz sands, ceramic powders, sand, chalk, fibers, hollow spheres and glass beads, emulsifiers, thixotropic agents, and film-forming aids.

10. The coating system according to any one of claims 1 to 9, wherein the dissipative synthetic resin layer (4) contains one more conductive additives for setting the electrical properties, for example, carbon fibers, carbon black, graphite, silicon carbide, metal oxides, metals such as iron, ammonium salts, heavy metal-containing or metal-containing fillers, especially antimony- and tin-containing fillers based on titanium dioxide or mica, ionic liquids, ionic and nonionic surfactants, melamine sulfonates and polycarboxylate ethers.

11. The coating system according to any one of claims 1 to 10, wherein the system resistance is less than 10⁹ ohm and/or the body voltage is less than 100 volt, measured according to IEC-61340-4-5.

12. A method for producing a coating system on a substrate (1) for the protection against electrostatic discharge according to any one of claims 1 to 15, comprising the following steps:
a) Applying an undercoat composition to the substrate (1) and curing to form an undercoat (2);
b) optionally applying, and curing, a scratch coat to the undercoat for leveling
c) applying a reaction resin composition to the undercoat or the scratch coat and curing to form a non-dissipative synthetic resin layer (3);
d) installing a grounding device on the non-dissipative synthetic resin layer (3) for grounding the coating system;
e) applying a reaction resin composition over the grounding device and the non-dissipative synthetic resin layer (3) and curing to form the dissipative synthetic resin layer (4) having a resistance to ground according to VDE-0100-410 of at least 100 kohm.

13. A method for converting an existing coating system, comprising in the following order a) an undercoat (2) on the substrate (1), optionally a scratch coat for leveling, and b) a non-dissipative synthetic resin layer (3), for producing a coating system on a substrate (1) for the protection against electrostatic discharge according to any one of claims 1 to 15, comprising the following steps:
a) installing a grounding device on the non-dissipative synthetic resin layer (3) of the existing coating system to ground the coating system; and
b) applying a reaction resin composition over the grounding device and the non-dissipative synthetic resin layer (3) and curing to form the dissipative synthetic resin layer (4) having a resistance to ground according to VDE-0100-410 of at least 100 kohm.

14. The method for renovating a coating system on a substrate (1) for the protection against electrostatic discharge according to any one of claims 1 to 11 in which the dissipative synthetic resin layer (4) is partially worn away, comprising:
a) applying a reaction resin composition over the dissipative synthetic resin layer (4) and curing to form the dissipative synthetic resin layer (4) having a resistance to ground according to VDE-0100-410 of at least 100 kohm.

15. The method according to either claim 13 or 14, wherein, before applying the new dissipative synthetic resin layer (4), the existing partially worn away dissipative synthetic resin layer (4), or before installation of the grounding device, the existing non-dissipative synthetic resin layer (3) is subjected to a pretreatment, for example, grinding, sand-blasting, shot-blasting or stripping with solvents or acids.

## Revendications

1. Système de revêtement sur un substrat (1) pour la protection contre le déchargement électrostatique, comprenant dans cet ordre :
a) une couche de base (2) sur le substrat (1),
b) une couche de résine artificielle non conductrice (3) et
c) une couche de résine artificielle conductrice (4) ayant une résistance de mise à la terre selon VDE-0100-410 d'au moins 100 kOhm,
un dispositif de mise à la terre pour la mise à la terre du système de revêtement étant agencé entre la couche de résine artificielle conductrice (4) et la couche de résine artificielle non conductrice (3).

2. Système de revêtement selon la revendication 1, dans lequel le système de revêtement est un système de revêtement de sol.

3. Système de revêtement selon la revendication 1 ou la revendication 2, dans lequel le système de revêtement ne comprend pas de film conducteur (5).

4. Système de revêtement selon l'une quelconque des revendications 1 à 3, dans lequel un ragréage pour l'égalisation est agencé entre la couche de base (2) et la couche de résine artificielle non conductrice (3).

5. Système de revêtement selon l'une quelconque des revendications 1 à 4, dans lequel la couche de résine artificielle non conductrice (3) présente une épaisseur de couche dans la plage allant de 0,5 à 20 mm et/ou dans lequel la couche de résine artificielle conductrice (4) présente une épaisseur de couche dans la plage allant de 20 à 5 000 µm.

6. Système de revêtement selon l'une quelconque des revendications 1 à 5, dans lequel la couche de résine artificielle non conductrice (3) et/ou la couche de résine artificielle conductrice (4) présentent une émission de COVT très faible.

7. Système de revêtement selon l'une quelconque des revendications 1 à 6, dans lequel la couche de résine artificielle non conductrice (3) présente une résistance de mise à la terre de plus de 10⁹ Ohm, déterminée selon IEC 61340-4-1 et/ou dans lequel la couche de résine artificielle conductrice (4) présente un résistance de mise à la terre inférieure ou égale à 10⁹ Ohm, déterminée selon IEC 61340-4-1.

8. Système de revêtement selon l'une quelconque des revendications 1 à 7, dans lequel les couches de résine artificielle (3) et (4) et la couche de base de résine artificielle sont formées par des résines réactives ou matériaux à base de résines réactives durcis, qui contiennent éventuellement un ou plusieurs additifs, les résines réactives qui sont utilisées pour chaque couche ou couche de base étant choisies indépendamment les unes des autres parmi les résines époxyde, les polyuréthanes, les polyurées, les mélanges de polyuréthanes et de polyurées, les polyméthacrylates, les polyacrylates, les systèmes hybrides cimenteux et les mélanges cimenteux améliorés au polymère (PCC).

9. Système de revêtement selon l'une quelconque des revendications 1 à 8, dans lequel un ou plusieurs additifs choisis parmi les solvants et l'eau, les agents colorants, tels que les quartz colorés, les colorants, les pigments et les paillettes de couleur, les charges, telles que les arènes, les poudres céramiques, le sable, la craie, les fibres, les billes creuses et les perles de verre, les émulsifiants, les agents thixotropes, les adjuvants filmogènes sont contenus dans la couche de résine artificielle non conductrice (3).

10. Système de revêtement selon l'une quelconque des revendications 1 à 9, dans lequel un ou plusieurs additifs conducteurs pour l'ajustement des propriétés électriques sont contenus dans la couche de résine artificielle conductrice (4), p. ex. des fibres de carbone, du noir de carbone, du graphite, du carbure de silicium, des oxydes de métaux, des métaux, tels que le fer, des sels d'ammonium, des charges contenant des métaux lourds ou contenant des métaux, notamment des charges contenant de l'antimoine et de l'étain à base de dioxyde de titane ou de mica, des liquides ioniques, des tensioactifs ioniques et non ioniques, des sulfonates de mélamine et des éthers de polycarboxylate.

11. Système de revêtement selon l'une quelconque des revendications 1 à 10, dans lequel la résistance du système est inférieure à 10⁹ Ohm et/ou la tension au niveau du corps (« body voltage ») est inférieure à 100 Volt, mesurée selon IEC-61340-4-5.

12. Procédé de fabrication d'un système de revêtement sur un substrat (1) pour la protection contre le déchargement électrostatique selon l'une quelconque des revendications 1 à 15, comprenant les étapes suivantes :
a) l'application d'une composition de couche de base sur le substrat (1) et le durcissement pour former une couche de base (2),
b) éventuellement l'application et le durcissement d'un ragréage sur la couche de base pour l'égalisation,
c) l'application d'une composition de résine réactive sur la couche de base ou le ragréage, et le durcissement pour la formation d'une couche de résine artificielle non conductrice (3),
d) le montage d'un dispositif de mise à la terre sur la couche de résine artificielle non conductrice (3) pour la mise à la terre du système de revêtement,
e) l'application d'une composition de résine réactive sur le dispositif de mise à la terre et la couche de résine artificielle non conductrice (3), et le durcissement pour la formation de la couche de résine artificielle conductrice (4) présentant une résistance de mise à la terre selon VDE-0100-410 d'au moins 100 kOhm.

13. Procédé d'adaptation d'un système de revêtement déjà existant qui comprend, dans cet ordre, a) une couche de base (2) sur le substrat (1), éventuellement un ragréage pour l'égalisation, et b) une couche de résine artificielle non conductrice (3), pour la fabrication d'un système de revêtement sur un substrat (1), pour la protection contre le déchargement électrostatique selon l'une quelconque des revendications 1 à 15, comprenant les étapes suivantes :
a) le montage d'un dispositif de mise à la terre sur la couche de résine artificielle non conductrice (3) du système de revêtement déjà existant pour la mise à la terre du système de revêtement, et
b) l'application d'une composition de résine réactive sur le dispositif de mise à la terre et la couche de résine artificielle non conductrice (3), et le durcissement pour la formation de la couche de résine artificielle conductrice (4) présentant une résistance de mise à la terre selon VDE-0100-410 d'au moins 100 kOhm.

14. Procédé de réhabilitation d'un système de revêtement sur un substrat (1) pour la protection contre le déchargement électrostatique selon l'une quelconque des revendications 1 à 11, dans lequel la couche de résine artificielle conductrice (4) est partiellement usée, comprenant :
a) l'application d'une composition de résine réactive sur la couche de résine artificielle conductrice (4) et le durcissement pour la formation de la couche de résine artificielle conductrice (4) présentant une résistance de mise à la terre selon VDE-0100-410 d'au moins 100 kOhm.

15. Procédé selon l'une quelconque des revendications 13 ou 14, dans lequel, avant l'application de la nouvelle couche de résine artificielle conductrice (4), la couche de résine artificielle conductrice (4) partiellement usée déjà présente, ou avant le montage du dispositif de mise à la terre, la couche de résine artificielle non conductrice (3) déjà présente est soumise à un prétraitement, tel que p. ex. un meulage, un sablage, un grenaillage ou un lessivage avec des solvants ou des acides.
